# EUROPEAN PATENT SPECIFICATION

(11) **EP 4 028 478 B1**
(45) Date of publication and mention of the grant of the patent: **17.04.2024**
(21) Application number: 20768345.9
(22) Date of filing: 10.09.2020
(51) Int. Cl.: C09D 5/34, C09D 15/00, C09J 4/00, B05D 3/02, B05D 3/06, G03F 7/38, G03F 7/027

(54) **METHOD OF COATING A SUBSTRATE USING AN ACCELERATOR-FREE COATING COMPOSITION**
VERFAHREN ZUR BESCHICHTUNG EINES SUBSTRATS MIT EINER BESCHLEUNIGERFREIEN BESCHICHTUNGSZUSAMMENSETZUNG
PROCÉDÉ DE REVÊTEMENT D'UN SUBSTRAT À L'AIDE D'UNE COMPOSITION DE REVÊTEMENT SANS ACCÉLÉRATEUR

(30) Priority: 13.09.2019 EP 19197362
(43) Date of publication of application: 20.07.2022
(73) Proprietor: Akzo Nobel Coatings International B.V., 1077 WW Amsterdam (NL)
(72) Inventor: STRIDH, Lars-Erik Jörgen, 23635 Höllviken (SE); OLSSON KARLBERG, Nils Gustav Martin, 247 56 Dalby (SE); ANDERSSON, Niclas Nils Erik, 233 76 Klågerup (SE); HENRIKSSON, Patrik Birger Otto, 214 43 Malmö (SE); SJÖDAHL, Claes Gunnar Stefan, 386 93 Färjestaden (SE); RONNERMARK, Carl Johan Joachim, 231 68 Trelleborg (SE)
(74) Representative: Akzo Nobel IP Department
(86) International application number: PCT/EP2020/075358
(87) International publication number: WO 2021/048293

(56) References cited:
- EP-A1- 2 342 287
- US-A- 5 922 473
- US-A1- 2014 228 465
- US-A1- 2017 183 513
- US-B2- 6 852 765
- US-B2- 10 000 588

## Description

### Field of the invention

The present invention relates to a method of coating a substrate using an accelerator-free coating composition, particularly a cobalt-free (Co-free) wood putty composition.

### Background

Coating of substrates with UV-curable coating compositions gained more popularity in many fields due to fast cure and low amounts of solvents (if at all used). An example of such field is wood and particle board manufacture. The surface of the boards, including its edges, is typically coated for protection and/or decorative purposes. The surface can also contain surface defects, which need repair by filling holes and other surface defects with a certain depth with a putty composition. After application the coating or putty is cured. Typically, wood putties used for surface repair are heavily pigmented to match the color of the wood and make the repair spot less visible.

EP 2342287 A1 concerns a heat-curable powder coating composition which can be cured at low temperature and is therefore suitable for use on heat-sensitive substrates such as wood.

There is a lot of interest in UV-curable coating compositions, which do not need solvents to be applied to the wood and similar substrates, and which can be cured very fast using UV light. A conventional UV-curable coating composition typically contains unsaturated compounds such as (meth)acrylate monomers or oligomers, which undergo radical polymerization upon exposure to UV light in the presence of a photoinitiator.

US 10,000,588 B2 concerns a UV curable coating for the inner surface of plastic bottles, which coating comprises an unsaturated compound, a thermal initiator and a photoinitiator.

UV cure is effective for thin layers of coating compositions and will not penetrate deeper layers, especially in case of heavily pigmented coatings e.g. putties. For the deep cure of such coatings, it is known to further use thermal initiators, such as organic peroxides. The peroxides would typically decompose when heated to a certain temperature and start the radical reaction. The decomposition temperature of the organic peroxides used in wood putties is normally much higher than the room temperature, for the reasons of safety. Since wood repair is normally done at nearly ambient conditions, this means that the putty composition also needs to contain an accelerator, in order to start the decomposition of the peroxide at a room temperature. Typically, cobalt (Co) salts are used for this.

However, the use of cobalt compounds became restricted due to health and environmental concerns. It is therefore desired to provide a method for coating wood and other non-conductive substrates using UV-curable coatings with a decreased amount of Co compounds, or preferably free of Co compounds. It is also desired that such method achieves both surface and in-depth cure of the coating within short curing times. It is further desired to provide coatings which are Co-free or substantially Co-free.

### Summary of the invention

In order to address the above-mentioned desires, the present invention provides, in a first aspect, a method of coating a non-conductive substrate, said method being a method for repairing a surface defect of a wood substrate, said method comprising the steps of:
a) applying a wood putty composition to the substrate, wherein the wood putty composition comprises:
   i) at least one unsaturated compound,
   ii) a thermal initiator comprising an organic peroxide,
   iii) a photoinitiator, and
   iv) at least one pigment,
   wherein the wood putty composition is free of accelerator, capable of decreasing the activation energy of the thermal initiator, particularly, free of Co compounds,
b) exposing the wood putty composition to UV light effective to start polymerization of the unsaturated compound,
c) exposing the wood putty composition to microwave heating effective to decompose the thermal initiator,
wherein step c) is performed either simultaneously with step b) or sequentially after step b).

### Detailed description of the invention

The method according to the present invention makes it possible to coat a non-conductive substrate, particularly a wood substrate with a wood putty composition that is free or substantially free of cobalt compounds. The method uses a so-called dual cure mechanism, wherein the wood putty composition, after application to the substrate, is cured by both photopolymerization and thermal polymerization. Although dual cure methods are known in the art of wood manufacture, none of such methods makes it possible to use cobalt free wood putties.

Preferably, the substrate is a non-conducting substrate, such as solid wood or engineered wood product.

The method is particularly useful for solid wood substrates (natural wood) since these often have surface defects of irregular shapes, varying depths and locations. Solid wood refers to natural wood as opposed to engineered wood products. The latter are manufactured by binding together wood strands, fibers, or veneers with adhesives to form a composite material. Solid wood boards often have surface defects of a certain depth such as holes, knots, splits, cracks. The defects can either originate from the manner of handling wood or have a natural origin.

The method of the present invention can also be used for engineered wood products, such as plywood, medium-density fiberboard (MDF), high density fiberboard (HDF), Oriented strand board (OSB) and particle board (chipboard). Further examples of suitable substrates include stone (marble, quartz, limestone, sandstone, granite), plastics (PVC, polyurethane, polycarbonate, polyethylene.

If natural wood is used as the substrate, it is preferably dried before the application of the wood putty . Preferably, it is dried to less than 10 wt.% moisture, more preferably the moisture content is in the range 5-9 wt.%. The moisture (water) content in the wood is defined as the weight of the water in damp material divided by the weight of the material in a dry state. Moisture content in wood can be measured by electrical resistance moisture meters.

In step a) of the method according to the present invention, a wood putty composition is applied to the substrate. The application can for example be done manually, e.g. with a spatula, or mechanically with the use of a device, e.g. by spraying, extruding, molding, curtain coating, vacuum coating, flow coating or roller coating.

In step b) the applied wood putty composition is exposed to UV light effective to start the photopolymerization of the unsaturated compounds in the coating composition. As a UV light source a UV lamp can be used emitting UV-light with a wavelength in the range 150-440 nm. The UV lamp can have a peak irradiance from 10 mW/cm² to 100 W/cm², preferably from 100 mW/cm² to 30 W/cm². The radiation source can for example be a mercury vapor UV lamp, including mercury doped with Ga or Fe, or a LED emitting radiation lamp. The radiation emitted by the LED lamp can for example have a wavelength from 200 to 440 nm, preferably in the range 250-350 nm. In other embodiments, a wavelength in the range 350-440 nm can be found more suitable. A skilled person is able to determine the suitable light exposure requirements based on the specific lamp to be used, such as intensity, total dose and the time of exposure.

In step c) the wood putty composition is exposed to microwave heating effective to decompose the thermal initiator contained in the composition and start radical polymerization. The particular equipment for microwave heating is not critical to the invention. Any suitable source of microwaves can be used, e.g. a microwave oven. The typical frequencies are in the range 5 GHz - 300 MHz. Preferably, the microwave source has an output power in the range 1-50 kW and exposure times 1 s - 10 min. The heating should be sufficient in order to decompose the thermal initiator, which then contributes to in-depth polymerization of the wood putty composition. The specific power and exposure time necessary for this can easily be determined by a skilled person, based on the specific organic peroxide to be used as the thermal initiator.

It is important that the thermal polymerization (step c)) is performed not earlier than the photopolymerization (step b)). This means that step c) is performed either simultaneously with step b) or sequentially after step b). An advantage of first cure with UV is that the wood putty composition can be pre-gelled to the extent that it is not sticky anymore.

The method according to the invention can be implemented as a batch method, or as a continuous method. Preferably, the method according to the invention is a continuous method. For example, a continuous method arrangement can include boards on a transport band, which pass the relevant steps of the process.

The method according to the invention preferably does not involve conductive heating of the substrate. The only heating of the substrate is preferably done by microwave heating. The preceding steps (e.g. steps a) and b)) are preferably carried out at an ambient temperature (i.e. 15-35°C).

The wood putty composition useful in the present invention comprises:
i) at least one unsaturated compound,
ii) a thermal initiator comprising an organic peroxide, and
iii) a photoinitiator, and
iv) at least one pigment.

Unsaturated compounds (i) contain at least one unsaturated bond, e.g. double bond. This bond takes part in the polymerization reaction, once activated by an initiator. Unsaturated compounds i) can for example be selected from multifunctional (meth)acrylates, unsaturated polyesters, or any mixture thereof. Preferably, the unsaturated compound is a (meth)acrylate, particularly a multifunctional (meth)acrylate or mixtures thereof. Under "multifunctional (meth)acrylate compound" a compound is meant, which has at least one (meth)acrylate functionality. The designation "(meth)acrylate" means methacrylate or acrylate. Both monomers and oligomers can be used, including their mixtures. Multifunctional (meth)acrylate functional compounds are commonly used for photopolymerization.

In some embodiments, the (meth)acrylate compound can be a polyester (meth)acrylate oligomer, a (meth)acrylate urethane, an epoxy (meth)acrylate.

Polyester (meth)acrylates can be obtained from a reaction of a polyester polyol and a carboxylic acid functional acrylate such as acrylic acid, methacrylic acid, or a combination thereof. The polyester polyol is prepared from at least one hydroxyl functional compound and at least one carboxylic acid functional compound. The hydroxyl functional compound can for example be a diol or a tri-functional or higher polyol. The polyol may be aromatic, cycloaliphatic, aliphatic. The carboxylic acid functional compound can be a dicarboxylic acid, a polycarboxylic acid. It can be aliphatic, cycloaliphatic, aromatic.

Commercially available multifunctional (meth)acrylate compounds include polyester acrylate resins such as Ebecryl 851, Ebecryl 852, Ebecryl 856 from Allnex, Laromer LR 8981, Laromer LR 9004, Laromer PE 9074, Laromer PE 44 F, Laromer PE 55 F, Laromer PE 56 F, Laromer PE 9032 from BASF, Sartomer CN 203, Sartomer CN 2295, Sartomer CN 2505 from Arkema.

The wood putty composition can further comprise at least one reactive diluent. Reactive diluents are capable of reacting with the (meth)acrylate compound during polymerization and at the same time, they reduce the viscosity of the putty composition. The reactive diluent may have a molecular weight Mn from 200 to 2000. Preferably, the reactive diluent has a (meth)acrylate functionality from 1 to 5. Suitable reactive diluents include (meth)acrylic acid, hexane diol di(meth)acrylate, pentaerythritol tri(meth)acrylate, dimethylol propane tri(meth)acrylate, isodecyl (meth)acrylate, dipropylene glycol diacrylate, tripropylene glycol diacrylate, glycerol propoxylated triacrylate, trimetylolpropane triacrylate, propoxylated neopentyl glycol diacrylate.

The multifunctional (meth)acrylate compound is preferably present in an amount of from 10 to 90 wt.%, more preferably from 20 to 80 wt.% in the wood putty composition, based on the total weight of the composition.

The thermal initiator (ii) used in the present invention comprises at least one organic peroxide or a mixture of organic peroxides. Organic peroxides are organic compounds containing a bond -O-O-, which easily decompose at heating thereby generating radicals. Organic peroxides can be generally divided in diacylperoxides, hydroperoxides, dialkylperoxides, peroxyesters, peroxyketals and peroxy(di)carbonates.

Organic peroxides can be characterized by self-accelerating decomposition temperature (SADT), which is the lowest temperature at which the organic peroxide undergoes self-accelerating decomposition. SADT can be determined based on the Heat Accumulation Storage Test, which is a recognized test method for the determination of the SADT of organic peroxides (see Recommendations on the Transport of Dangerous Goods, Manual of Tests and Criteria - United Nations, New York and Geneva, section 28.4.4).

In some embodiments of the present invention, the organic peroxide has a SADT of higher than 30°C, preferably higher than 35°C, more preferably higher than 40°C. In some embodiments, the SADT is preferably higher than 45°C, more preferably higher than 50°C or higher than 55°C. Preferably, the SADT is below 90°C, more preferably below 85°C, yet more preferably below 80°C. The most preferred SADT range useful in the present invention is from 50 to 75°C, or from 55 to 70°C. A too low SADT generally means that the organic peroxide is difficult to handle without initiating decomposition unintentionally. A too high SADT would mean that the peroxide would require too high temperatures and hence energy input to decompose.

Particularly preferred organic peroxides include methyl ethyl ketone peroxide and cyclohexanone peroxide. They are commercially available for example as Butanox M-50A (SADT 60°C), Cyclonox LR (SADT 60°C), Cyclonox LE-50 (SADT 50°C).

Although less suitable for the present invention, organic peroxides can also be characterized by their decomposition rate, which is determined using its half life time. The half-life is the time taken for half of the peroxide quantity to decompose in a specific solvent at a given temperature. With the exception of hydroperoxides, the half-life times are usually determined using a solution of the peroxide (0.1 mol/l) in monochlorobenzene. Half-life temperatures at which the half-lives are 10h, 1h and 1 min, are usually given by the manufacturer of the peroxide. In some embodiments of the present invention, it is preferred to have an organic peroxide with a 1h half-life temperature of at least 100°C, more preferably of at least 130°C, yet more preferably at least 140°C. Generally, 1h half-life temperature is preferably below 190°C.

The thermal initiator is preferably present in an amount of from 0.05 wt.% to 5 wt.%, more preferably from 0.1 wt.% to 3 wt.% based on the total weight of the wood putty composition.

The wood putty composition used in the present invention is preferably free, or substantially free, of any accelerator. Substantially free means that less than 100 ppm of an accelerator can be present. Accelerators are often used together with high-temperature thermal initiators and serve to lower the activation energy of the thermal initiator and, consequently, to speed up the curing rate at room temperature. Typical accelerators are metal salts, e.g. cobalt salts such as Co naphthenate.

While being free or substantially free from any accelerator, the wood putty composition contains an organic peroxide with a relatively high SADT, which hence does not decompose at room temperature. These, at first sight, two contradictory requirements form the essence of the present invention, wherein the thermal initiation of the wood putty composition is affected by microwaves instead of use of accelerators or conventional, conductive heating.

Microwave heating is particularly useful for treating non-conductive substrates such as wood and stone, because conductive heating is very difficult due to high specific heat value of such substrates. In addition, it is difficult to achieve uniform heating of large pieces of wood when it is heated from outside, e.g. placed in an oven. Microwave heating does not have these disadvantages; it penetrates inside the substrate and provides for even heating. When the wood putty composition is a pigmented wood putty, microwaves also facilitate better in-depth thermal initiation and hence curing of the putty in deep and shadow spots, which cannot be reached by the UV light used in the photopolymerization step.

The wood putty composition further comprises iii) a photoinitiator, capable of initiatiing the photopolymerization when exposed to UV light. Any known and suitable photoinitiator can be used. Examples include benzophenones, phosphine oxides, acetophenone derivatives and cationic photoinitiators such as triaryl sulfonium salts and aryliodonium salts. Suitable commercial photoinitiators include for example Omnirad 1173, Omnirad 184, Omnirad MBF, Omnirad 754, Omnirad TPO-L, Omnirad 819, Omnirad ITX from IGM. A skilled person is able to choose a photoinitiator suitable for a specific UV source and the necessary amount thereof.

Typically, photoinitiator is present in an amount of from 0.05 wt.% to 10 wt.%, more preferably from 0.1 wt.% to 8 wt.% based on the total weight of the wood putty composition.

Preferably, the wood putty composition is opaquely pigmented. The wood putty composition comprises iv) at least one pigment. Particularly preferred are opaque, color pigments (non-white), more particularly brown pigments, which match the color of the wood surface, but other pigments and their mixtures can also be used. Typical color pigments used in wood putties are those imparting red, yellow, green, blue, black colors to the putty composition, and combinations thereof. Generally, the color pigment content is preferably in the range 0.01-30 wt.%. In some embodiments, the content of pigment should at least be 3 wt.% and up to 25 wt.%, preferably from 4 wt.% to 10 wt.% based on the total weight of the wood putty composition. In other embodiments, content of pigments can be 0.01-1 wt.%, preferably 0.01-0.15 wt.% based on the total weight of the composition.

The pigment can also be a white pigment, particularly, TiO₂, which can be used for white coatings. White pigments can be present in an amount 1-60 wt.% based on the total weight of the composition.

The wood putty composition may further comprise a filler. Suitable fillers include calcium carbonate, barium sulfate, mica, alumina, clays such as kaolin, china clay, zirconium oxide, barium oxide, calcium oxide, magnesium silicate, calcium silicate, aluminum silicates, magnesium calcium carbonate, aluminum hydroxide. In some embodiments, the wood putty composition may comprise fillers in an amount in the range 1-90 wt.%, preferably 10-80 wt.%, based on the total weight of the wood putty composition. In some embodiments it may be preferred to have a filler content of 50 wt.% or more.

The wood putty composition can also comprise conventional ingredients known in the art. Examples of those are defoaming agents, surfactants, rheology modifiers, dispersants, adhesion promoters, stabilizers. The amounts of these additives are typically from 0.1 to 10 wt.% based on the total weight of the wood putty composition. In some embodiments, the wood putty composition used in the present invention does not contain substantial amounts of water or solvents and is a so-called "100% solid" composition. This means that the wood putty composition contains less than 0.5 wt.% of water or solvents, based on the total weight of the wood putty composition.

The liquid state of the wood putty composition will in that case be due to the presence of low molecular weight compounds such as reactive diluents.

In other embodiments it may be preferred to use organic solvents, for example aromatic solvents, such as toluene or benzene, and non-aromatic solvents, such as acetone, chloroform, dichloromethane, butyl acetate or ethyl acetate. Typically, the amount of solvent would be from 0.1 to 50 wt.% based on the total weight of the wood putty composition.

Existing, Co-containing wood putties are typically provided as two-component (2K) compositions. For such putties it is necessary to have the organic peroxide and the Co accelerator in different components so as to prevent them from reaction before the application.

An advantage of the present invention is that the wood putty composition can be provided as a 1K composition, since it does not contain compounds with a low SADT and since it needs microwaves to initiate thermal curing. In some cases, it can however be preferred to provide the wood putty composition as a 2K composition with, for example, the thermal initiator to be provided as a second component. If provided as a 2K composition, its pot life is very long, longer than 24 hours and typically at least 1-2 weeks and longer, at room temperature. This is much longer than the pot life of conventional, Co-containing 2K wood putties, which is typically between 20 min and 20 hours at room temperature.

Another advantage of the present invention is short curing time. It is possible to achieve full cure nearly instantaneously. Conventional, Co-containing 2K wood putties typically need 0.5-8 hours for full cure at room temperature, which is limited by the reaction speed of the peroxide decomposition in the presence of the Co accelerator. The decomposition of the thermal initiator upon exposure to microwaves is however much faster and full cure can be achieved in less than a minute.

The method according to the invention permits to coat a surface, e.g. a wood surface, with a Co-free wood putty composition thereby achieving full cure within acceptable time, independently of the thickness of the wood putty and depth of the surface defect to be repaired. Full cure can be evaluated based on the residual monomer content, which is determined based on gas chromatography. The method according to the present invention makes it possible to achieve residual monomer content of less than 1000 mg/m².

The invention will now be illustrated based on the following examples. Unless otherwise specified, all percentages and amounts expressed in this specification refer to percentages by weight.

### Examples

### Example 1

Different acrylate binders are mixed in a plastic jar with a thermal initiator and cured according to different procedures A-C. A is cured with microwaves, B is only conductively heated in an oven, C uses a traditional Co-accelerator and cured at room temperature.

A. 20 g of the acrylate binder or monomer as specified in Table 1 is mixed with 2 wt.% Butanox M-50A and then submitted to household microwaves (800W). The treatment time is indicated in Table 1 as the time necessary to achieve curing.

B. 20 g of acrylate binder or monomer as specified in Table 1 is pre-heated to 70°C and then mixed with 2 wt.% Butanox M-50A and then kept at 70°C.

C. 20 g of acrylate binder or monomer as specified in Table 1 is mixed with 0.1 wt.% Borchers Deca Cobalt 10 and 2 wt.% Butanox M-50A and kept at 22°C (room temperature).

**Table 1**

| Acrylate | Curing time / method | | |
|---|---|---|---|
| | A | B | C |
| Miramer P2229 | 25 sec | 7 min, wet on surface | partly gelled after 24 h |
| Ebecryl 3708 | 30 sec | 1-2 h | no reaction after 24 h |
| Ebecryl 11 | 15 sec | 5 min | no reaction after 24 h |
| Sartomer CN 131 B | 40 sec | partly gelled after 24 h | no reaction after 24 h |
| Ebecryl 4175 | 20 sec | cured after 3 h | cured after 3 h |

Miramer^{®} P2229 - trifunctional polyester acrylate from Miwon Specialty Chemical Co., Ltd.

Ebecryl^{®} 3708 is a modified bisphenol A epoxy diacrylate by Allnex.

Ebecryl^{®} 11 is a polyethylene glycol diacrylate derivative by Allnex.

Sartomer^{®} CN 131B is an aromatic monoacrylate oligomer by Arkema Group.

Ebecryl^{®} 4175 is a hard unsaturated wax-free polyester resin, diluted with 25% dipropylene glycol diacrylate, by Allnex.

### Example 2

In this example coating compositions were prepared and applied to a wood substrate.

A mixture including Ebecryl^{®} 4175, mixed according to procedure A above, cured within 30 seconds on wood.

A putty was prepared including 61.45 parts by weight of commercial acrylate binders and acrylate monomers, 20 parts by weight filler, 27 parts by weight of rheological additives, the remaining 10.55 parts by weights being pigments, an anti-oxidant and a stabilizer. The composition did not comprise any photoinitiators. The putty was mixed with a peroxide according to procedure A above. Curing took place after 90 seconds in a plastic jar, and after 60 seconds for a film applied on a wood substrate.

An unsaturated polyester (Roskydal 502 BA from Allnex) was mixed with peroxide according to procedure A above. Curing took place after 90 seconds both in a plastic jar and for a film applied on wood.

### Example 3

The putty composition from Example 2 was prepared with additionally 4.2 wt.% photoinitiators (4 wt.% 1-hydroxycyclohexyl phenyl ketone, 0.2 wt.% BAPO) on the total weight of the putty composition.

The putty was mixed with a peroxide according to procedure A above. Curing took place after 60 seconds on a wood composite substrate (MDF) and after 90 seconds on a plastic substrate (polypropylene and polyethylene were tested).

### Example 3

The putty composition from Example 3 was applied to an MDF panel, which was then subjected to a modified procedure A, wherein UV curing took place before microwave curing.

For UV curing a combination of Hg and Ga lamps was used with the total dose 5000 mJ/cm². After the UV curing, the surface was dry but deeper layers remain unreacted. After 60 seconds of microwave curing of this sample, the entire sample is cured.

## Claims

1. Method of coating a non-conductive substrate, said method being a method for repairing a surface defect of a wood substrate, said method comprising the steps of:
a) applying a wood putty composition to the wood substrate, wherein the wood putty composition comprises:
i) at least one unsaturated compound,
ii) a thermal initiator comprising an organic peroxide,
iii) a photoinitiator, and
iv) at least one pigment,
wherein the wood putty composition is free of accelerator, capable of decreasing the activation energy of the thermal initiator, particularly, free of Co compounds,
b) exposing the wood putty composition to UV light effective to start polymerization of the unsaturated compound,
c) exposing the wood putty composition to microwave heating effective to decompose the thermal initiator,
wherein step c) is performed either simultaneously with step b) or sequentially after step b).

2. The method according to claim 1, wherein the unsaturated compound is a multifunctional (meth)acrylate compound, an unsaturated polyester, or a mixture thereof.

3. The method according to claim 1 or 2, wherein the self-accelerating decomposition temperature (SADT) of the organic peroxide is at least 30°C.

4. The method according to claim 3, wherein the organic peroxide is selected from methyl ethyl ketone peroxide and cyclohexanone peroxide.

5. The method according to any one of claims 1-4, wherein the substrate is selected from the list consisting of solid wood and engineered wood products.

## Patentansprüche

1. Verfahren zum Beschichten eines nichtleitenden Substrats, wobei es sich bei dem Verfahren um ein Verfahren zur Reparatur eines Oberflächendefekts eines Holzsubstrats handelt, wobei das Verfahren die folgenden Schritte umfasst:
a) Aufbringen einer Holzkittzusammensetzung auf das Holzsubstrat, wobei die Holzkittzusammensetzung Folgendes umfasst:
i) mindestens eine ungesättigte Verbindung,
ii) einen thermischen Initiator, der ein organisches Peroxid umfasst,
iii) einen Photoinitiator und
iv) mindestens ein Pigment,
wobei die Holzkittzusammensetzung frei von Beschleuniger, der dazu in der Lage ist, die Aktivierungsenergie des thermischen Initiators zu erniedrigen, und insbesondere frei von Co-Verbindungen ist,
b) Einwirkenlassen von UV-Licht, das zum Starten der Polymerisation der ungesättigten Verbindung wirksam ist, auf die Holzkittzusammensetzung,
c) Einwirkenlassen von Mikrowellenerhitzen, das zur Zersetzung des thermischen Initiators wirksam ist, auf die Holzkittzusammensetzung, wobei Schritt c) entweder gleichzeitig mit Schritt b) oder sequenziell nach Schritt b) durchgeführt wird.

2. Verfahren nach Anspruch 1, wobei es sich bei der ungesättigten Verbindung um eine multifunktionelle (Meth)acrylatverbindung, einen ungesättigten Polyester oder eine Mischung davon handelt.

3. Verfahren nach Anspruch 1 oder 2, wobei die SADT (Self-Accelerating Decomposition Temperature) des organischen Peroxids mindestens 30 °C beträgt.

4. Verfahren nach Anspruch 3, wobei das organische Peroxid aus Methylethylketonperoxid und Cyclohexanonperoxid ausgewählt wird.

5. Verfahren nach einem der Ansprüche 1-4, wobei das Substrat aus der Liste bestehend aus Massivholz und Holzwerkstoffprodukten ausgewählt wird.

## Revendications

1. Procédé de revêtement d'un substrat non conducteur, ledit procédé étant un procédé pour la réparation d'un défaut de surface d'un substrat de bois, ledit procédé comprenant les étapes de :
a) application d'une composition de mastic à bois sur le substrat de bois, la composition à mastic de bois comprenant :
i) au moins un composé insaturé,
ii) un initiateur thermique comprenant un peroxyde organique,
iii) un photoinitiateur, et
iv) au moins un pigment,
la composition de mastic à bois étant exempte d'accélérateur, capable de diminuer l'énergie d'activation de l'initiateur thermique, particulièrement, exempte de composés du Co,
b) exposition de la composition de mastic à bois à de la lumière UV efficace pour débuter la polymérisation du composé insaturé,
c) exposition de la composition de mastic à bois à un chauffage par microondes efficace pour décomposer l'initiateur thermique,
l'étape c) étant réalisée soit simultanément avec l'étape b), soit séquentiellement après l'étape b).

2. Procédé selon la revendication 1, le composé insaturé étant un composé de (méth)acrylate multifonctionnel, un polyester insaturé ou un mélange correspondant.

3. Procédé selon la revendication 1 ou 2, la température de décomposition auto-accélérante (SADT) du peroxyde organique étant d'au moins 30 °C.

4. Procédé selon la revendication 3, le peroxyde organique étant choisi parmi le peroxyde de méthyléthylcétone et le peroxyde de cyclohexanone.

5. Procédé selon l'une quelconque des revendications 1 à 4, le substrat étant choisi dans la liste constituée par du bois solide et des produits de bois transformé.
